## Europäisches Patentamt
## European Patent Office
## Office européen des brevets

(19)

(11) Publication number: **0 053 939**
**B1**

(12)

# EUROPEAN PATENT SPECIFICATION

(45) Date of publication of patent specification: **16.05.84**

(21) Application number: **81305777.5**

(22) Date of filing: **08.12.81**

(51) Int. Cl.³: **H 03 L 7/00, H 04 L 27/22, H 04 L 7/02**

(54) Digital phase locked loop pull-in circuitry.

(30) Priority: **09.12.80 JP 172672/80**

(43) Date of publication of application:
**16.06.82 Bulletin 82/24**

(45) Publication of the grant of the patent:
**16.05.84 Bulletin 84/20**

(84) Designated Contracting States:
**DE FR GB**

(56) References cited:
US-A-3 952 253
US-A-3 962 637

PATENTS ABSTRACTS OF JAPAN, vol. 4, no. 189, December 25, 1980, page 671 E 39

ELECTRONIC ENGINEERING, vol. 47, no. 569, July 1975, LONDON, GB M.N.Y. SHUM: "DIGITAL PLL WITH ADJUSTABLE CENTRE FREQUENCY", pages 6-7

(73) Proprietor: **FUJITSU LIMITED**
**1015, Kamikodanaka Nakahara-ku**
**Kawasaki-shi Kanagawa 211 (JP)**

(72) Inventor: **Ihira, Kuninosuke**
**12-3, Miyamaedaira 3-chome**
**Takatsu-ku Kawasaki-shi Kanagawa. 213 (JP)**
Inventor: **Unagami, Shigeyuki**
**2451-79, Iriya 4-chome**
**Zama-shi Kanagawa. 288 (JP)**
Inventor: **Kaku, Takashi**
**488-2-2, Takaishi, Tama-ku**
**Kawasaki-shi Kanagawa. 215 (JP)**

(74) Representative: **Sunderland, James Harry et al**
**HASELTINE LAKE & CO Hazlitt House 28**
**Southampton Buildings Chancery Lane**
**London WC2A 1AT (GB)**

# 0 053 939

**Description**

The present invention relates to digital phase locked loop pull-in circuitry.

In a high speed data communication system a timing pull-in sequence, whereby a digital phase locked loop is synchronised to the phase of a received signal, must be effected in order that correct data is provided at the receiver. The digital phase locked loop is used for such phase synchronisation. Generally, a digital phase locked loop has been synchronised with the phase of a received signal by changing the division factor by which a frequency from a high frequency oscillator in the receiver is divided. However, such circuits have required a comparatively long period for phase synchronisation and it has not been easy to realise phase synchronisation within a short period of time.

For reducing pull-in time for phase synchronisation, in United States Patent No. 3,962,637 a method has been proposed. In that proposed method the following process is carried out. A phase error $\phi$ is obtained from the relationship

$$\phi = 1 - \frac{1}{45°} \cdot \tan \frac{YQ_1}{YQ_0},$$

which employs two adjacent demodulated samples ($YQ_0$, $YQ_1$) of the received signal, and synchronisation is established by effecting control such that the phase error $\phi$ is reduced to zero. However, that proposed method has a disadvantage in that a conversion table, which performs conversion between phase error and

$$1 - \frac{1}{45°} \cdot \tan^{-1} \frac{YQ_1}{YQ_0},$$

needs to be large. This is because whilst sample values $YQ_0$, $YQ_1$ may take values over a range from zero to a non-zero finite value, the range of values of the ratio of sample values, $|YQ_1/YQ_0|$, is from zero to infinity so that the value of $\tan^{-1}|YQ_1/YQ_0|$ can range from zero to infinity. Thus, a large scale conversion table must be provided. An attempt to employ a small scale conversion table has required complicated control.

According to the present invention there is provided circuitry operable to assess the phase difference between first and second signals, comprising:

a sample circuit, operable to sample the first signal at two timing, determined in dependence upon the second signal, spaced apart in relation to the phase of the first signal, to provide first and second samples,

comparator means, operable to assess the relationship between the absolute values of the first and second samples, and to provide an output indicative thereof,

an amplitude ratio circuit, operable to determine the ratio of the amplitudes of the first and second samples, and to provide an output indicative thereof,

and a conversion table operable to provide a value indicative of the said phase difference, in dependence upon the signs of the first and second samples, and the outputs of the comparator means and the amplitude ratio circuit.

In particular, such circuitry is applicable in a digital phase locked loop pull-in circuit.

Such circuitry can be employed in a data modem, etc, and in particular in relation to a circuit which synchronises the phase of a digital phase locked loop clock to a single frequency signal extracted from a received signal. Such circuitry can be provided with a simple structure and can operate at high speed.

An embodiment of the present invention can provide for the elimination of disadvantages of existing systems, by detecting phase difference using a conversion table of a simplified structure, and thereby realising high speed phase synchronisation.

An embodiment of the present invention can provide accurate synchronisation for a pull-in sequence, and can be applied to general modems.

Briefly, an embodiment of the present invention provides a high speed digital phase locked loop pull-in circuit which obtains a phase difference between a single frequency signal and an output signal of the digital phase locked loop, which output signal is obtained by dividing a specified frequency, wherein comprised are a sample circuit which obtains sample values of said single frequency signal at two points of said output signal of the digital phase locked loop corresponding to the phase difference of $\pi/2$ of said single frequency signal, a comparator circuit which compares absolute values of said two sample values, an amplitude ratio circuit which obtains the amplitude ratio of the two sample values, and a conversion table for obtaining a value corresponding to said phase difference based on the sign bits of the two sample values, the output of the comparator circuit and the output of the amplitude ratio circuit, and wherein the initial value of the dividing counter is set by an output of the conversion table.

Further, another embodiment of the present invention provides a high speed digital phase locked

2

loop pull-in circuit which obtains a phase difference between a single frequency signal and the output signal of the digital phase locked loop, which output signal is obtained by dividing the specified frequency, wherein comprised are a sample circuit which samples said single frequency signal at two points of said output of the digital phase locked loop corresponding to the phase difference of $\pi/2$ radians, a magnitude comparator circuit which compares the absolute values of said two sample values, an amplitude ratio circuit which obtains the amplitude ratio of the two sample values, and a conversion table which obtains a value corresponding to the supplementary angle of said phase difference, from the sign bits of said two sample values, the output of said comparator circuit and the output of said amplitude ratio circuit, and wherein said dividing counter ceases operation for a period corresponding to said supplementary angle based on the output of said conversion table.

The comparator circuit in an embodiment of the present invention may comprise absolute value networks which take respective absolute values of the two sample values, and a subtractor which obtains the difference between the outputs of the absolute value networks.

The amplitude ratio circuit in an embodiment of the present invention may comprise a selection circuit which selectively connects the two outputs of the two absolute value networks respectively to first or second paths in one of which a reciprocal network is connected, in dependence upon the output of the subtractor, and a multiplier to which are input signals sent from the first and second paths.

In an embodiment of the present invention there may be provided a phase detector which receives as input the output signal of the digital phase locked loop and the sample value and detects a phase difference between them, and a remove tooth network which thins output pulses of an oscillator which provides the specified frequency signal, in accordance with the output of the phase detector.

An embodiment of the present invention may also comprise a down counter which counts down from a value corresponding to the supplementary angle, a first gate which opens when a count value of the down counter becomes zero and which then connects the dividing counter to the oscillator, and a second gate which opens when a count value of the dividing counter becomes zero and is controlled by a sequencer.

Reference is made, by way of example, to the accompanying drawings, in which:—

Figure 1 is schematic block diagram of a modem receiver in which an embodiment of the present invention can be employed,

Figure 2 is a schematic block diagram of an embodiment of the present invention,

Figure 3 is a schematic block diagram illustrating one example of the structure of a calculator 65 as shown in Figure 2,

Figure 4 is a waveform diagram in which (a) illustrates an output signal of a digital phase locked loop, (a)' illustrates a sampling clock $f_s$, (b) illustrates a phase locked condition, and (c) illustrates a condition in which phases are not synchronised and a phase difference $\phi$ exists,

Figure 5 is a phase diagram illustrative of the relationship between sample values and phase angle $\phi$ on the phase plane,

Figure 6 is a phase diagram illustrating how the positions of sample values on the phase plane depend upon their signs,

Figure 7 is a phase diagram illustrating how the positions of sample values on the phase plane depend upon differences between their absolute values,

Figure 8 illustrates the relationships beween the position of a sample on the phase plane and the signs of sample values and the difference between absolute values of sample values, and

Figure 9 is a schematic block diagram of another embodiment of the present invention.

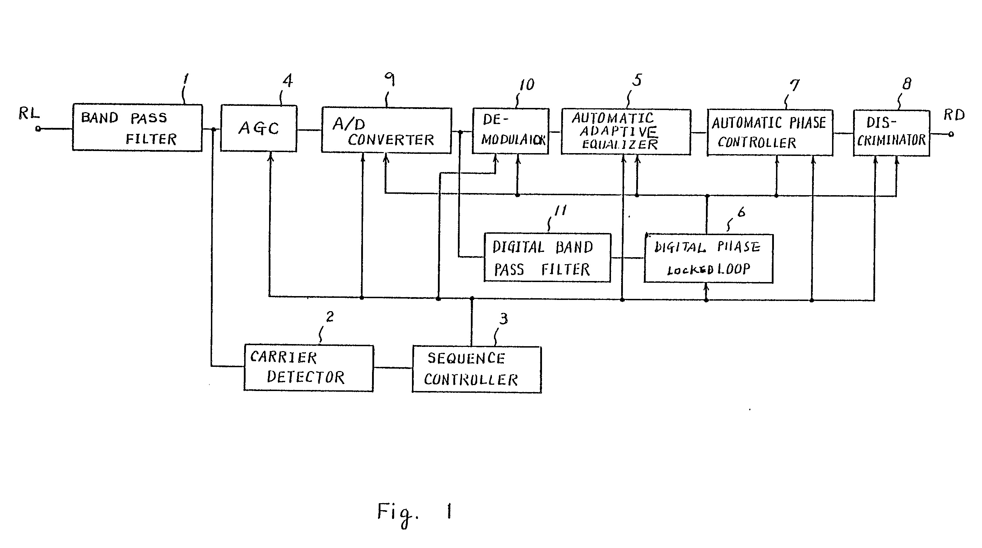

Figure 1 is a schematic block diagram of a data modem receiver in which an embodiment of the present invention can be employed.

In Figure 1, is a band pass filter, 2 is a carrier detector, 3 is a sequence controller, 4 is an automatic gain controller (AGC), 5 is an automatic adaptive equaliser, 6 is a digital phase locked loop, 7 is an automatic phase controller, 8 is a discriminator, 9 is an analog to digital converter, 10 is a demodulator, 11 is a digital band pass filter, RL is an input terminal, and RD is an output terminal.

The present invention relates to the phase locked loop 6.

For explanation of the background of the present invention, the operation of the data modem shown in Figure 1 is outlined below.

For the data modem shown in Figure 1, an input receiving signal is a modulated analog signal. This analog signal has been sent from a transmitter as a phase modulated signal containing phase information. Digital signals of several bits length, of different values, are taken to correspond to respective specified phases on the phase plane, and the transmitted signal is phase-modulated in accordance with such digital signals.

The phase modulated signal sent from the transmitter, through a transmission line, is received at the terminal RL, outband signal components are eliminated by the band pass filter 1 and the presence of carrier at greater than a constant amplitude (—26 dBm for example) is detected by the carrier detector 2. Thus, the sequence controller 3 is started. This sequence controller 3 controls the automatic gain controller 4, automatic adaptive equaliser 5, phase locked loop 6, automatic phase controller 7, and discriminator 8, at a constant period. Meanwhile, an output of the band pass filter 1 is amplified up to a constant average level by the automatic gain controller 4, then converted into a digital signal by the analog to digital converter 9 and moreover demodulated by the demodulator 10. This demodulated signal will in practice include distortion resulting from transmission through the transmission line and phase deviation from the carrier signal. Such distortion is compensated by the automatic adaptive equaliser 5 and phase deviation is compensated by the automatic phase controller 7. Thus, a digital signal the same as the transmitted signal is provided by the discriminator 8 and output as a receiving output signal (RD).

Reference timing for such processing of an input receiving signal is supplied respectively to the analog to digital converter 9, demodulator 10, automatic adaptive equaliser 5, automatic phase controller 7, and discriminator 8, etc, by the digital phase locked loop 6.

In order to receive correctly the phase modulated signal, the receiver must provide phase synchronisation between the input receiving signal and reference timing in the receiver.

For this purpose, a single frequency signal is extracted from the input receiving signal via a narrow band pass filter and phase synchronisation between this single frequency signal and reference timing in the receiver is carried out. Thereby, phase synchronisation between the input receiving signal and reference timing is established.

Embodiments of the present invention relate to the phase locked loop 6 for establishing phase synchronisation between the input receiving signal and reference timing in the receiver as explained above.

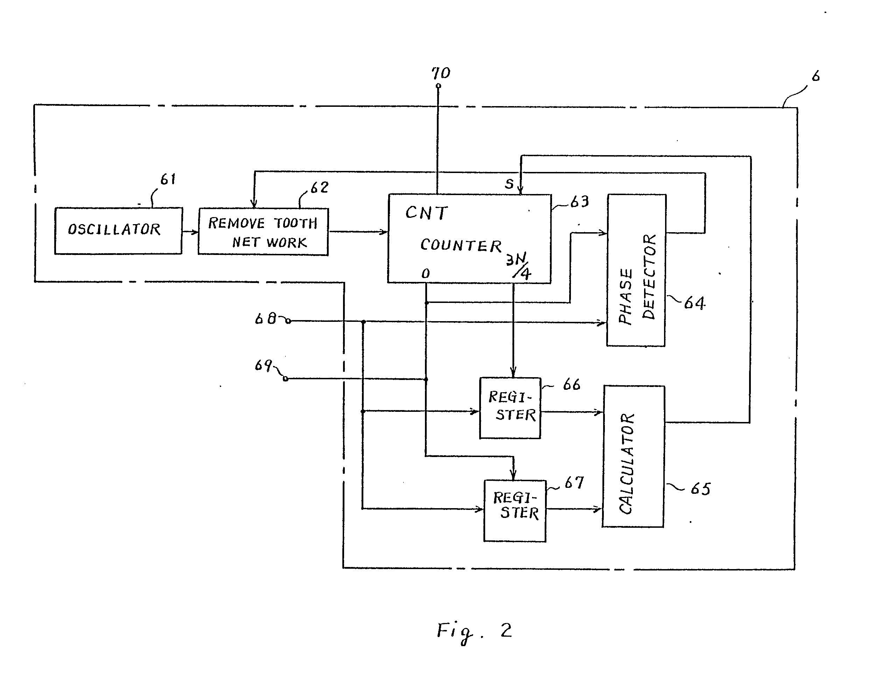

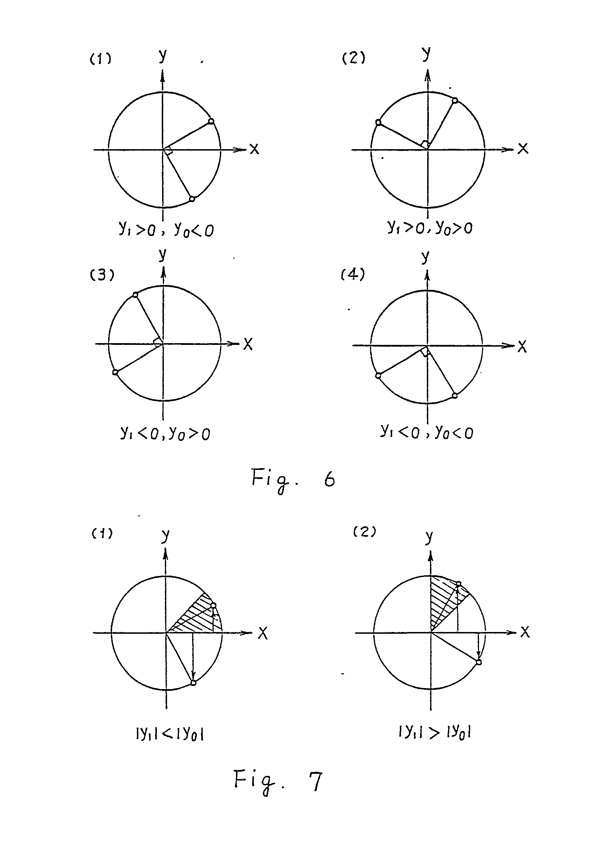

Figure 2 is a schematic block diagram of an embodiment of the present invention. In Figure 2, 6 is a digital phase locked loop, 61 is an oscillator, 62 is a remove tooth network, 63 is a counter, 64 is a phase detector, 65 is a calculator, 66 and 67 are registers, 68 is an input terminal connected to the digital band pass filter 11 shown in Figure 1, 69 is an output terminal of the phase locked loop 6, and 70 is an input terminal connected to the sequence controller 3 of Figure 1.

A high frequency signal is output from the oscillator 61 and this output signal is divided by the counter 63 and output from the terminal 69 as an output signal of the digital phase locked loop (CL). A start signal for pull-in of the digital phase locked loop is input from the sequence controller 3 to counter 63 through the terminal 70.

The single frequency signal $f_R$ extracted from the input receiving signal is input to the terminal 68 and then to the phase detector 64 for a phase comparison between the signal $f_R$ and the output signal of the digital phase locked loop (CL), which is an output of the counter 63. Thus, phase difference information (derived on the basis of the comparison in detector 64), is input to the remove tooth network 62. As a result, the output of oscillator 61 is thinned in accordance with the phase difference information and phase pull-in is effected. In the illustrated embodiment of the invention, the frequency of oscillator 61 is 614.5 kHz, and the frequency division ratio N of the counter 63 is 256, and $f_R$ is 240 Hz.

For a general background understanding of pull-in for phase synchronisation the following sources may be useful. J. R. Cessna and D. M. Levy: "Phase Noise and Transient Times for a Binary Quantized Digital Phase-Locked Loop in White Gaussian Noise" IEEE Trans. COM—20, 2, P94 (April 1972); Proc. IEEE Vol. 69 No. 4, P401 to 431, "A Survey of Digital Phase-Locked Loops"; IEEE transactions communication Vol. 28 No. 8 P1197 to 1294 "Digital PCM Bit Synchronizer and Detector" etc.

In the illustrated embodiment of the present invention the registers 66 and 67, calculator 65 and an initial setting terminal of the counter 63 are provided in order to pull-in the initial phase at the first input point of a receiving signal.

In general terms, the signal input to the input terminal 68 is obtained by digitalising the input receiving signal in an analog to digital converter 9 and corresponds to sample values of a single frequency signal $f_R$ which is extracted via the digital band pass filter 11. The frequency of signal $f_R$ is equivalent to the symbol rate of the phase modulation of the input receiving signal.

Sample values are input to registers 66 and 67, and moreover are input to the calculator 65.

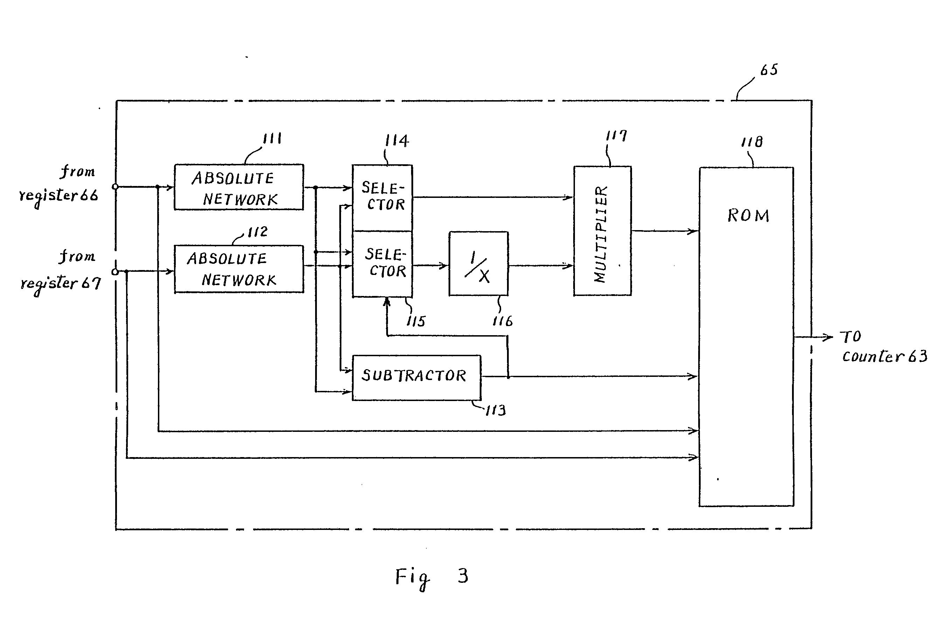

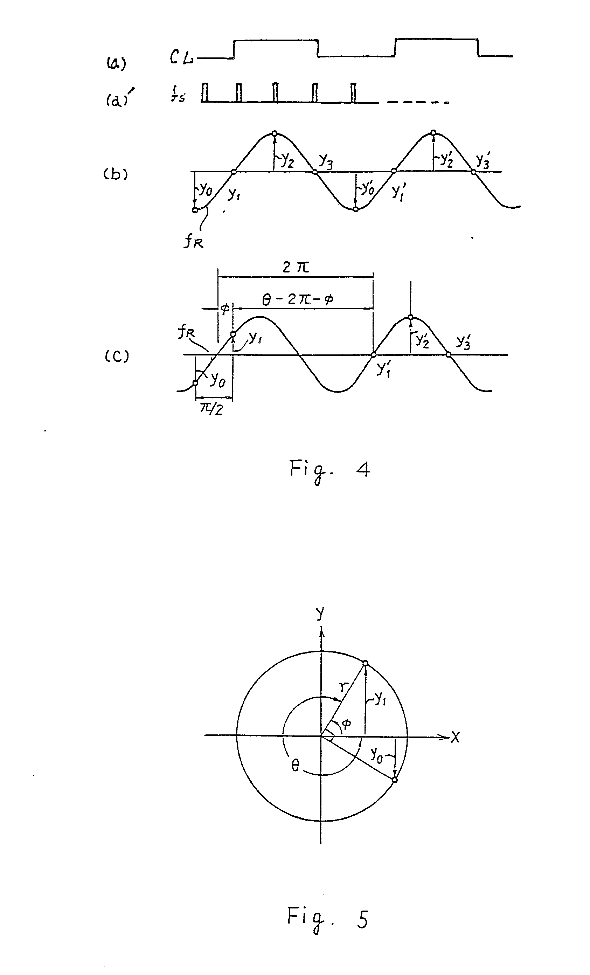

Initial setting is then effected by obtaining an initial set value for the counter from the sign bits of sample values and from comparison of absolute values as explained in more detail below, the phase synchronisation is carried out. The structure of the calculator 65 is one embodiment of the present invention is shown in Figure 3, but a general explanation of the nature of the present invention will be given first with reference to Figures 4 to 8, to facilitate understanding, prior to a detailed explanation of the operation of the calculator of Figure 3.

Waveform (a) of Figure 4 represents an output signal (CL) of the digital phase locked loop obtained from the terminal 69 shown in Figure 2. Waveform (a)' of Figure 4 represents a sampling clock $f_S$, whilst waveforms (b) and (c) of Figure 4 respectively illustrate conditions in which phase synchronisation with (between CL and) single frequency signal $f_R$ is achieved, and in which a phase difference exists between CL and $f_R$.

In the waveforms of Figure 4, $y_0, y_1, y_2, \ldots$ are sample values of the signal $f_R$ at the output points of the output signal of the digital phase locked loop (CL) (the signal $f_R$ is sampled at timings determined with respect to the output signal CL).

Here, the sampling signal $f_S$ used for sampling signal $f_R$ is four times the frequency of the output signal (CL). Such a frequency relationship is such that a sample is taken at each phase change of $\pi/2$ in output

signal CL, such that a sample can be provided to be output in respect of every phase difference of $\pi/2$ of the signal $f_R$. Therefore, the phase interval between the sample values $y_0$ and $y_1$, $y_2$ correspond to a phase advance of $\pi/2$ radians.

Assuming that the signal $f_R$ of waveform (b) of Figure 4 is phase locked with the output signal of the digital phase locked loop, the timings of zero-crossings of signal $f_R$ match the timings of sample values $y_1$, $y_3$, $y_1'$. Therefore, the values of sample values $y_1$, $y_3$, $y_1'$ are all zero. Waveform (c) of Figure 4 illustrates a condition in which the signal $f_R$ is asynchronised, a phase difference $\phi$ existing between $f_R$ and the output of the digital phase locked loop. Since the criterion of phase is selected to be the zero-crosspoint where the signal $f_R$ shifts to the plus sign from to the minus sign, a phase difference $\phi$ extends from the zero-crosspoint to the timing of sample $y_1$. That is, the criterion by which phase synchronisation between $f_R$ and CL is judged is synchronisation of the zero points of $f_R$ and CL at which those respective signals change from plus to minus. In the case of waveform (c) a phase difference or error $\phi$ is present which is reflected in the difference in timings between the relevant zero point of $f_R$ and the sample value $y_1$.

For the condition illustrated in waveform (c), the relationship between the sample values $y_0$, $y_1$ can be indicated on the phase plane as shown in Figure 5.

In Figure 5, the relationship between sampling value and phase angle $\phi$ is indicated by a rotating vector of radius r. The relationship between the sampling values $y_1$, $y_0$ and the phase angle are respectively as expressed by equation (1) and (2).

$$y_1 = r \sin \phi \qquad (1)$$

$$y_0 = r \sin (\phi - \pi/2) = -r \cos \phi \qquad (2)$$

Equation (3) can be obtained by dividing equation (1) by equation (2).

$$y_1/y_0 = -\tan \phi \qquad (3)$$

Therefore, phase angle $\phi$ can be expressed by the following equation (4).

$$\phi = \tan^{-1} (-y_1/y_0) \qquad (4)$$

Here, since a value of $\tan^{-1} (-y_1/y_0)$ can be obtained, from equation (4), a phase difference $\phi$ corresponding to that value can also be obtained. As a circuit structure for obtaining $\phi$, a conversion table using a ROM etc is usually employed, as the desired $\phi$ can be obtained by providing an output corresponding to $\tan^{-1} (-y_1/y_0)$.

This value $\phi$ corresponds to a difference $\phi$ as explained with reference to waveform (c) of Figure 4.

Here, a conversion table provides an output corresponding to an input value in the relationship of 1:1, corresponding to the specified input. That is, for each input value the conversion table provides a respective output value. A conversion table could be established in accordance with equation (4) such that when a ratio of sample values $y_0$ and $y_1$ is input, a corresponding value $\phi$ is output. For a conversion table, a ROM (Read Only Memory) is usually employed because of circuit structure considerations, and outputs corresponding to respective addresses are provided for each specified address in the ROM and outputs corresponding to designated addresses are delivered from the ROM. The ratio of sample values $y_0$ and $y_1$ corresponds to an address.

However, the inventors of the present invention have considered the significance of the signs (plus and minus) of the sample values $y_0$ and $y_1$. As shown in Figure 6, the quadrant (of the phase plane) in which $y_1$ exists can be determined from those signs. Namely, in the case illustrated in Figure 6 (1), $y_1 > 0$, $y_0 < 0$, and the angle between $y_1$ and $y_0$ is $\pi/2$. Therefore, it will be understood that $y_1$ exists in the first quadrant. In the case illustrated in Figure 6 (2), $y_1 > 0$, $y_0 > 0$ and it will be understood that $y_1$ exists in the second quadrant. In the case illustrated in Figure 6 (3), $y_1 < 0$, $y_0 > 0$, and it will be understood that $y_1$ exists in the third quadrant. In the case of Figure 6 (4), $y_1 < 0$, $y_0 < 0$, and it will be understood that $y_1$ exists in the fourth quadrant. Knowing the signs of $y_1$ and $y_0$ it is thus possible to determine the quadrant of the phase plane in which $\phi$ lies. Knowing the quadrant in which $\phi$ lies, $\phi$ can be determined by deriving the angle, between zero and $\pi/2$, at which $\phi$ lies within the known quadrant. For this purpose use can be made of the following equation.

$$\phi = \tan^{-1} y_1/y_0 \qquad (5)$$

However, if a value of $\phi$ is obtained from equation (5), it should be noted that the value of $|y_1/y_0|$ can still lie in the range from zero to infinity.

The inventors of the present invention have also considered the significance of the absolute values of the sample values. If the absolute values $|y_0|$ and $|y_1|$ of the samples $y_0$ and $y_1$ are compared. It can be determined in which half of a quadrant $\phi$ lies. Figure 7 (1) and (2) illustrate this in relation to the first quadrant. The first half of the first quadrant is shaded in Figure 7 (1) and the second half is shaded in Figure 7 (2). It will be understood that if $|y_1|<|y_0|$ then, as illustrated in Figure 7 (1), $y_1$ (and $\phi$) lies in the first half of the first quadrant. If $|y_1|>|y_0|$ then as illustrated in Figure 7 (2) $y_1$ (and $\phi$) lies in the second half of the first quadrant.

Thus, the phase plane can be divided into eight equal areas, and the area in which the timing of sample value $y_1$ exists can be determined from the signs of sample values $y_0$ and $y_1$ and from the result of comparison of the absolute values of those sample values.

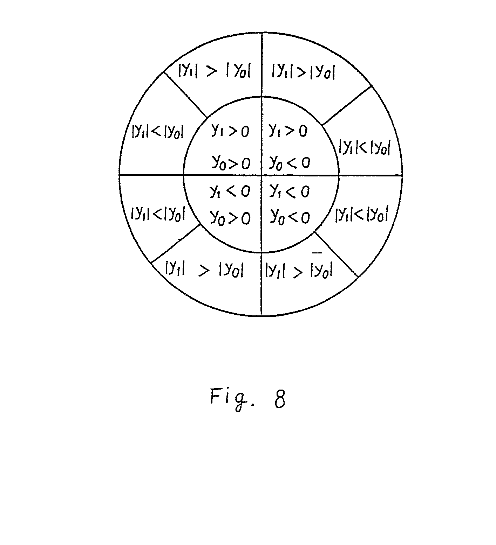

Figure 8 indicates how a sample $y_1$ can be determined to lie in a particular half quadrant. By Figure 8 it is illustrated that the range in which a phase difference exists, on a phase plane divided equally into eight areas, can be determined from the result of comparison between $|y_1|$ and $|y_0|$ and the signs of $y_1$ and $y_0$.

Now, knowing the half quadrant in which $\phi$ lies, $\phi$ can be determined by deriving the angle, between zero and $\pi/4$, at which $\phi$ lies in a half quadrant.

Thus, considering equation (5), and any half quadrant, the value of $|y_1/y_0|$ can take any value within the range from 0 to 1. Therefore, in place of equation (5) the following equations (6) and (7) can be employed, in which the larger of $y_0$ and $y_1$ is placed in the denominator whilst the smaller is placed in the numerator.

$$\phi_x = \tan^{-1} |y_1/y_0 \,|, \text{ where } |y_1\,|\leqslant |y_0\,| \tag{6}$$

$$\phi_x = \tan^{-1} |y_0/y_1 \,|, \text{ where } |y_0\,|\leqslant |y_1\,| \tag{7}$$

Equation (6) indicates an angle between the x-axis of the phase plane and $y_1$, whilst equation (7) indicates an angle between the y-axis of the phase plane and $y_1$. This will be clear from the relationship, $\tan (\pi/2 -\phi) = 1/\tan \phi$.

From the above explanation, it will be understood and in relation to any of the eight areas of the phase plane divided equally into eight areas, a phase difference between the signal $f_R$ and the timing value $y_1$ can be determined and specified by $\phi_x$, $\phi_y$ which lie in the range from 0 to $\pi/4$ radians.

Table 1 below illustrates the relationship between phase difference $\phi$ ($\theta = 2\pi -\phi$), between the signal $f_R$ at the timing of sample value $y_1$, and the signs of $y_0$ and $y_1$, and the relationship between $|y_0|$ and $|y_1|$.

TABLE 1

| Phase of $y_1$ (×/4 radian) | Sign $y_0$ | $y_1$ | $\mid y_0 \mid$ $\mid y_1 \mid$ | $\phi$ | $\theta = 2\pi - \phi$ |
|---|---|---|---|---|---|
| 0 ~ 1 | | | > | $0 + \phi_x$ | $2\pi = \phi_x$ |
| 1 ~ 2 | − | + | < | $\pi/2 - \phi_y$ | $3\pi/2 + \phi_y$ |
| 2 ~ 3 | | | < | $\pi/2 + \phi_y$ | $3\pi/2 - \phi_y$ |
| 3 ~ 4 | + | + | > | $\pi - \phi_x$ | $\pi + \phi_x$ |
| 4 ~ 5 | | | > | $\pi + \phi_x$ | $\pi - \phi_x$ |
| 5 ~ 6 | + | − | < | $3\pi/2 - \phi_y$ | $\pi/2 + \phi_y$ |
| 6 ~ 7 | | | < | $3\pi/2 + \phi_y$ | $\pi/2 - \phi_y$ |
| 7 ~ 8 | − | − | > | $2\pi - \phi_x$ | $0 + \phi_x$ |

Returning to Figures 2 and 3, the embodiment of the present invention illustrated therein will now be explained.

When the sequence controller 3 is not exercising control over the counter 63, the counter 63 cyclically counts from zero to N. When the content of counter 63 reaches 3N/4, register 66 stores the signal $f_R$ corresponding to $y_0$, and when the content of the counter 63 is zero, register 67 stores the signal $f_R$ corresponding to $y_1$.

The sample values $y_0$, $y_1$ of the signal $f_R$ are respectively input to the registers 66, 67 shown in Figure 2. The sample values $y_0$, $y_1$ are then input to the calculator 65. An example of the structure of such a calculator 65 is shown in Figure 3. In Figure 3, 111, 112 are absolute networks, 113 is a subtractor, 114, 115 are selectors, 116 is a reciprocate network, 117 is a multiplier, and 118 is a ROM (Read Only Memory).

In Figure 3, the sample values $y_0$ and $y_1$ are respectively converted to absolute values $|y_0|$ and $|y_1|$ by the absolute networks 111 and 112. In digital calculation, such conversion is generally effected on the basis of 2's complements. The 2's complement value is negative when the maximum significant bit (MSB) of the value is 1, and positive when it is 0. The absolute networks 111 and 112 have structures similar to one another. When the MSB of an input signal to an absolute network is 1, the bit is inverted, but when the MSB is 0, the input is output directly, without inversion. Thus, approximate absolute values $|y_0|$ and $|y_1|$ are obtained as the output of absolute networks 111 and 112. The absolute values $|y_0|$ and $|y_1|$ are input to the subtractor 113, which delivers an output of logic value "1" when $|y_0|-|y_1| \geq 0$ and an output of logic value "0" when $|y_0|-|y_1| < 0$. The selector 114 passes either the output $|y_1|$ of the absolute network 112 or the output $|y_0|$ of the absolute network 111, depending upon the output, logic "1" or logic "0" of the subtractor 113. On the other hand, the selector 115 passes the output $|y_0|$ of the absolute network 111 or the output $|y_1|$ of the absolute network 112, depending upon the output, logic "1" or logic "0" of the subtractor 113 (e.g. the largest of $|y_0|$ and $|y_1|$). The reciprocate network 116 connected to the output of selector 115 is composed of a ROM (Read Only Memory) and outputs a number of reciprocal value of the output of the selector 115. The multiplier 117 multiplies an output of the selector 114 and an output of the reciprocate network 116. As output of the multiplier, either the value $|y_1/y_0|$ or the value $|y_0/y_1|$, each of which is within the range from 0 to 1, is obtained. The sign bits of $y_0$, $y_1$, an output sign bit of subtractor 113 and an output of multiplier 117 are respectively input to the read only memory ROM 118. This ROM 118 is used as the conversion table. The ROM is divided into eight areas according to three factors, that is, the sign bits of $y_0$, $y_1$ and the output of subtractor 113, and each part corresponds to one of eight phases of $y_1$ as shown in Table 1. Moreover, each part is sorted and addressed according to an output of the multiplier 117. This is illustrated in Table 2. In this table "(A) PHASE OF $y_1$" in the left most column corresponds to Table 1. The (B) column indicates the signs of sample values $y_1$ and $y_0$, the (C) column indicates the sign of $|y_0|-|y_1|$, the (D) column indicates the value of $|y_0|/|y_1|$ or of $|y_1|/|y_0|$ and the (E) column indicates the value to be set in the counter 63.

In the Table, ROM ADDRESS relates to inputs to ROM 118. In ROM ADDRESS, bit "9" and "10" respectively correspond to the sign bits of the output of registers 66 and 67, while ROM ADDRESS bit "8" corresponds to an output sign bit of the subtractor 113 and ROM ADDRESS bis "0" to "7" correspond to the output from the multiplier 117.

When the specified ROM ADDRESS is input, the corresponding ROM DATA from the (E) column is output. The ROM DATA is output as binary bits, of which corresponding decimal values are shown in Table 2.

TABLE 2

| | (B) sign $(y_0)$ | (C) sign $(y_1)$ | (D) sign $(|y_0| - |y_1|)$ | (D) $\dfrac{|y_0|}{|y_1|}$ or $\dfrac{|y_1|}{|y_0|}$ | (E) ROUND $\left(\dfrac{\phi N}{2\pi}\right)$  N = 256 |
|---|---|---|---|---|---|

| (A) PHASE OF $y_1$ (x $\pi/4$ radian) | ROM ADDRESS | | | | | | | | | | | ROM DATA binary | | | | | | | | decimal |
|---|---|---|---|---|---|---|---|---|---|---|---|---|---|---|---|---|---|---|---|---|
| | 10 | 9 | 8 | 7 | 6 | 5 | 4 | 3 | 2 | 1 | 0 | 7 | 6 | 5 | 4 | 3 | 2 | 1 | 0 | decimal |
| 0 ~ 1 | 1 | 0 | 0 | 0 | 0 | 0 | 0 | 0 | 0 | 0 | 0 | 0 | 0 | 0 | 0 | 0 | 0 | 0 | 0 | 0 |
| | 1 | 0 | 0 | 0 | 0 | 0 | 0 | 0 | 0 | 0 | 1 | 0 | 0 | 0 | 0 | 0 | 0 | 0 | 1 | 1 |
| | | ≀ | ≀ | | | ≀ | | | | | | | | ≀ | | | | | | ≀ |
| | 1 | 0 | 0 | 0 | 1 | 1 | 1 | 1 | 1 | 1 | 1 | 0 | 0 | 0 | 1 | 1 | 1 | 1 | 1 | 31 |
| | 1 | 0 | 0 | 1 | 0 | 0 | 0 | 0 | 0 | 0 | 0 | 0 | 0 | 1 | 0 | 0 | 0 | 0 | 0 | 32 |
| 1 ~ 2 | 1 | 1 | 1 | 0 | 0 | 0 | 0 | 0 | 0 | 0 | 0 | 0 | 1 | 0 | 0 | 0 | 0 | 0 | 0 | 64 |
| | | ≀ | ≀ | | | ≀ | | | | | | | | ≀ | | | | | | ≀ |
| | 1 | 1 | 1 | 1 | 0 | 0 | 0 | 0 | 0 | 0 | 0 | 0 | 0 | 1 | 0 | 0 | 0 | 0 | 0 | 32 |
| 2 ~ 3 | 0 | 1 | 1 | 0 | 0 | 0 | 0 | 0 | 0 | 0 | 0 | 0 | 1 | 0 | 0 | 0 | 0 | 0 | 0 | 64 |
| | | ≀ | ≀ | | | ≀ | | | | | | | | ≀ | | | | | | ≀ |
| | 0 | 1 | 1 | 0 | 0 | 0 | 0 | 0 | 0 | 0 | 0 | 0 | 1 | 1 | 0 | 0 | 0 | 0 | 0 | 96 |
| 3 ~ 4 | 0 | 0 | 0 | 0 | 0 | 0 | 0 | 0 | 0 | 0 | 0 | 1 | 0 | 0 | 0 | 0 | 0 | 0 | 0 | 128 |
| | | ≀ | ≀ | | | ≀ | | | | | | | | ≀ | | | | | | ≀ |
| | 0 | 0 | 0 | 1 | 0 | 0 | 0 | 0 | 0 | 0 | 0 | 0 | 1 | 1 | 0 | 0 | 0 | 0 | 0 | 96 |
| 4 ~ 5 | 0 | 1 | 0 | 0 | 0 | 0 | 0 | 0 | 0 | 0 | 0 | 1 | 0 | 0 | 0 | 0 | 0 | 0 | 0 | 128 |
| | | ≀ | ≀ | | | ≀ | | | | | | | | ≀ | | | | | | ≀ |
| | 0 | 1 | 0 | 1 | 0 | 0 | 0 | 0 | 0 | 0 | 0 | 1 | 0 | 1 | 0 | 0 | 0 | 0 | 0 | 160 |
| 5 ~ 6 | 0 | 1 | 1 | 0 | 0 | 0 | 0 | 0 | 0 | 0 | 0 | 1 | 1 | 0 | 0 | 0 | 0 | 0 | 0 | 192 |
| | | ≀ | ≀ | | | ≀ | | | | | | | | ≀ | | | | | | ≀ |
| | 0 | 1 | 1 | 1 | 0 | 0 | 0 | 0 | 0 | 0 | 0 | 1 | 0 | 1 | 0 | 0 | 0 | 0 | 0 | 160 |
| 6 ~ 7 | 1 | 1 | 1 | 0 | 0 | 0 | 0 | 0 | 0 | 0 | 0 | 1 | 1 | 0 | 0 | 0 | 0 | 0 | 0 | 192 |
| | | ≀ | ≀ | | | ≀ | | | | | | | | ≀ | | | | | | ≀ |
| | 1 | 1 | 1 | 1 | 0 | 0 | 0 | 0 | 0 | 0 | 0 | 1 | 1 | 1 | 0 | 0 | 0 | 0 | 0 | 224 |
| 7 ~ 8 | 1 | 1 | 0 | 0 | 0 | 0 | 0 | 0 | 0 | 0 | 0 | 0 | 0 | 0 | 0 | 0 | 0 | 0 | 0 | 256(0) |
| | | ≀ | ≀ | | | ≀ | | | | | | | | ≀ | | | | | | ≀ |
| | 1 | 1 | 0 | 1 | 0 | 0 | 0 | 0 | 0 | 0 | 0 | 1 | 1 | 1 | 0 | 0 | 0 | 0 | 0 | 224 |

When an output of ROM 118 is input to the initial value -set-terminal S of the counter 63 as shown in Figure 2, the sequence controller 3 shown in Figure 1 controls the counter 63. Thereby, the output content of ROM 118 is loaded into the counter 63. Thus, the initial phase pull-in is carried out between the signal $f_R$ and the output of the digital phase locked loop (CL) provided by the contents loaded into counter 63.

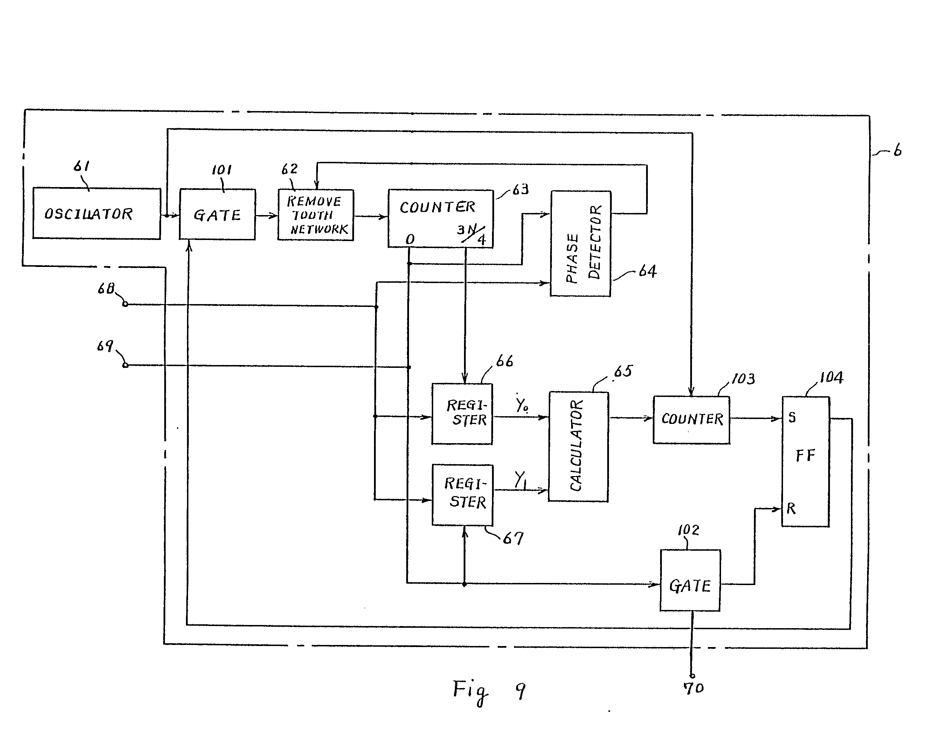

Figure 9 illustrates another embodiment of the present invention.

In Figure 9, oscillator 61, remove tooth network 62, counter 63, phase detector 64, calculator 65,

8

registers 66 and 67, and terminals 68 and 69 are items similar to those given corresponding reference numerals in Figure 2.

The embodiment illustrated in Figure 9 differs from that shown in Figure 2 in that gates 101 and 102, a second counter 103 and a flip-flop 104 are additionally provided. The operation of the embodiment of Figure 9 is similar to that of the embodiment shown in Figure 2 until sample values $y_0$ and $y_1$ are input to the registers 66 and 67. When the digital phase locked loop is running freely, without an input received signal, gate 102 closes, flip-flop 104 outputs logic "1", and gate 101 opens.

In the embodiment of Figure 9, the following operation is effected for providing initial phase pull-in by stopping the operation of the counter 63 for a time $\theta/2\pi f_R$ corresponding to the supplementary angle $\theta$ ($\theta$ indicated in Table 1) of phase $\phi$ at the timing of the sample value $y_1$, namely for allowing a count up to count value $N\theta/2\pi$ corresponding to $\theta$. When the contents of counter 63 becomes 0, and the sequence controller 3 shown in Figure 1 controls the gate 102, the gate 102 opens, making an output of the flip-flop 104 logic "0". As a result, the gate 101 closes and the remove tooth network 62 and counter 63 cease operation. Meanwhile, a value of $N\theta/2\pi$ is obtained at the calculator 65 based on the contents $y_0$ and $y_1$ of the registers 66 and 67 and this value $N\theta/2\pi$ is set in down counter 103. The counter 103 down counts on the basis of the clock signal sent from the oscillator 61: when the contents of counter 103 becomes zero, an output of the flip-flop 104 is set to logic "1" and the gate 101 opens. As a result, the counter 63 starts operation. Thereafter, operation as explained with reference to the embodiment of Figure 2 is carried out.

Thus, a preliminary pull-in operation is effected by stopping counter 63 for a time that it should recommence counting in phase (or at least approximately in phase) with $f_R$.

In the above explanation of operations of the embodiments of Figure 2 and Figure 9, any calculation time required for obtaining the phase angle $\theta$ and the supplementary angle $\theta$ has been ignored. If such calculation time cannot be ignored, it is necessary to include a phase corresponding to such calculation time in $\phi$ and $\theta$.

As explained previously, phase difference between an input single frequency signal, extracted from a received signal, and an output signal, of a digital phase locked loop can be obtained with a simplified structure by employing an embodiment of the present invention, and moreover a high speed phase pull-in can be realised by setting an initial set value of a counter in a phase locked loop in accordance with the obtained phase difference. Therefore, the circuit structure can be simplified and simultaneously the time required for synchronisation can be curtailed.

The above explanation has been given with reference to a sampling frequency 4 times the frequency of $f_R$, but a phase difference can be determined to within a range $2\pi/2n$ radian from the signs of sampling values and the relationship between their absolute values for freely selected n-time sampling. Thus, a detailed phase difference can be obtained in accordance with the following equation with ith and jth sampling values are respectively taken to be $y_i$ and $y_j$.

$$\tan^{-1} \frac{y_i \sin \dfrac{2\pi}{n} (j-i)}{y_j - y_i \cos \dfrac{2\pi}{n} (j-i)}$$

Embodiments of the present invention can be generally adopted to systems which realise phase pull-in for a reference clock when the input signal is a single frequency signal, and for example, embodiments of the present invention can be adopted in data modems etc.

With reference to counter 63 in Figures 2 and 9, the "0" output of the counter is provided at each instant at which the count content held in the counter is zero. Thus, when the frequency of oscillator 61 is 614.5 kHz and the frequency division ration N of the counter is 256, instants at which the count content is zero occur at a frequency of 2400 Hz, corresponding to the frequency of $f_R$. The operations of the illustrated embodiments of the present invention synchronise these zero-instants of counter 63 with zero points of $f_R$.

An embodiment of the present invention provides a digital phase locked loop circuit, in particular a circuit which can provide accurate digital phase locked loop pull-in operation at a high speed with a simplified circuit structure.

In embodiments of the present invention, in order to obtain the phase difference between a single frequency signal and the digital phase locked loop clock signal, obtained by dividing a signal of a specified frequency in a dividing counter, such phase difference is obtained in accordance with the signs, absolute values and amplitude ratio of two adjacent sample values, said sample values being taken of said single frequency signal at two points or instants set by the digital phase locked loop clock signal and corresponding to a phase change of $\pi/2$ radians of the single frequency signal, a fast pull-in of a digital phase lock loop is achieved by setting a value corresponding to the obtained phase difference into the dividing counter.

9

# O 053 939

**Claims**

1. Circuitry operable to assess phase difference between first and second signals ($f_R$, CL Fig. 4), comprising:

a sample circuit, operable to sample the first signal ($f_R$) at two timings, determined in dependence upon the second signal (CL), spaced apart in relation to the phase of the first signal, to provide first and second samples ($y_0$, $y_1$),

comparator means (113, Fig. 3), operable to assess the relationship between the absolute values of the first and second samples, and to provide an output indicative thereof,

an amplitude ratio circuit (114, 115, 116, 117), operable to determine the ratio of the amplitudes of the first and second samples, and to provide an output indicative thereof, and

a conversion table (118) operable to provide a value indicative of the said phase difference, in dependence upon the signs of the first and second samples, and the outputs of the comparator means and the amplitude ratio circuit.

2. A digital phase locked loop pull-in circuit, comprising circuitry as claimed in claim 1, wherein the first signal is a single frequency signal which is to be matched in phase by the second signal which is an output signal of a digital phase locked loop obtained by frequency dividing a signal of a pre-selected frequency by means of a dividing counter.

3. A circuit as claimed in claim 2, wherein the said value indicative of the said phase difference is employed to provide an initial count value for the dividing counter.

4. A circuit as claimed in claim 2, wherein the said value indicative of the said phase difference is a measure of the supplementary angle of a phase angle representative of the said phase difference, the circuit comprising means operable to prevent counting operations of the said dividing counter for a period corresponding to that supplementary angle.

5. A circuit as claimed in claim 4, comprising a down counter, in which the said value which is a measure of the supplementary angle is set, and which is operable to count down from that value, and a first gate connected beteen the dividing counter and an oscillator which provides the said signal of a pre-selected frequency, operable to open for passing the said signal of pre-selected frequency to the dividing counter when the down counter has counted down to zero.

6. Circuitry as claimed in claim 1, or a circuit as claimed in any one of claims 2 to 5, wherein the comparator means comprise an absolute value network operable to obtain the respective absolute values of the first and second samples, and a subtractor operable to determine the difference between the respective absolute values obtained by the absolute value network.

7. Circuitry, or a circuit, as the case may be, as claimed in claim 6, wherein the amplitude ratio circuit comprises selector means operable selectively to deliver the absolute values of the first and second samples to first and second paths, or to the second and first paths, respectively, in one of which paths a reciprocal value obtaining network is provided, in dependence upon the difference determined by the subtractor, and a multiplier connected to the first and second paths and operable to multiply values received therefrom.

8. A circuit as claimed in any one of claims 2 to 7, comprising a phase detector connected to receive an output signal of the digital phase locked loop, and one of the first and second samples, and to detect phase difference therebetween, and a remove tooth network operable to thin output pulses of an oscillator which provides the said signal of preselected frequency, in dependence upon the output of the phase detector.

9. Circuitry, or a circuit, as the case may be, as claimed in any preceding claim, wherein the said conversion table comprises a ROM.

10. Circuitry, or a circuit, as the case may be, as claimed in any preceding claim, wherein the said first signal is sampled at a frequency four times the frequency of the second signal, whereby the conversion table need provide values in respect of a $\pi/4$ range of phase differences.

**Revendications**

1. Montage ayant pour fonction d'évaluer le déphasage entre un premier et un deuxième signal ($f_R$, CL, figure 4), comprenant:

un circuit d'échantillonnage, ayant pour fonction d'échantillonner le premier signal ($f_R$) en deux instants, déterminés en fonction du deuxième signal (CL), séparés l'un de l'autre en relation avec la phase du premier signal, afin de produire un premier et un deuxième échantillon ($y_0$, $y_1$),

un moyen comparateur (113, figure 3), ayant pour fonction d'évaluer la relation existant entre les valeurs absolues des premier et deuxième échantillons, et de produire un signal de sortie indicatif de cette relation,

un circuit de détermination de rapport d'amplitude (114, 115, 116, 117) ayant pour fonction de déterminer le rapport des amplitudes des premier et deuxième échantillons, et de produire un signal de sortie indicatif de ce rapport, et

une table de conversion (118) ayant pour fonction de produire une valeur indicative dudit

10

# 0 053 939

déphasage, en fonction des signes des premier et deuxième échantillons, et des signaux de sortie du moyen comparateur et du circuit de détermination de rapport d'amplitude.

2. Circuit d'accrochage pour boucle à verrouillage de phase numérique, comprenant un circuit selon la revendication 1, où le premier signal est un signal de fréquence unique qui doit être adapté en phase par le deuxième signal qui est un signal de sortie d'une boucle à verrouillage de phase numérique obtenu par division de fréquence d'un signal d'une fréquence choisie à l'avance au moyen d'un compteur diviseur.

3. Circuit selon la revendication 2, où ladite valeur indicative dudit déphasage est employée pour fournir une valeur de comptage initiale pour le compteur diviseur.

4. Circuit selon la revendication 2, où ladite valeur indicative dudit déphasage est une mesure de l'angle supplémentaire d'un angle de phase représentatif dudit déphasage, le circuit comprenant un moyen ayant pour fonction d'empêcher des opérations de comptage dudit compteur diviseur pendant une durée correspondant à cet angle supplémentaire.

5. Circuit selon la revendication 4, comprenant un compteur descendant, dans lequel ladite valeur qui est une mesure de l'angle supplémentaire est positionnée, et qui a pour fonction de décompter à partir de cette valeur, et une première porte connectée entre le compteur diviseur et un oscillateur qui produit ledit signal d'une fréquence choisie à l'avance, ayant pour fonction d'ouvrir le passage audit signal de fréquence choisie à l'avance jusqu'au compteur diviseur lorsque le compteur descendant a décompté jusqu'à zéro.

6. Montage selon la revendication 1, ou circuit selon l'une quelconque des revendications 2 à 5, où le moyen comparateur comprend un réseau de prise de valeur absolue ayant pour fonction d'obtenir les valeurs absolues respectives des premier et deuxième échantillons, et un soustracteur ayant pour fonction de déterminer la différence entre les valeurs absolues respectives obtenues par la réseau de prise de valeur absolue.

7. Montage, ou circuit, suivant le cas, selon la revendication 6, où le circuit de détermination de rapport d'amplitude comprend un moyen sélecteur ayant pour fonction de sélectivement délivrer les valeurs absolues des premier et deuxième échantillons à un premier et un deuxième trajets, ou bien au deuxième et au premier trajet, respectivement, dans l'un desquels trajets est placé un réseau d'obtention de valeur inverse, en fonction de la différence déterminée par le soustracteur, et un multiplicateur connecté aux premier et deuxième trajets et ayant pour fonction de multiplier les valeurs qu'il en reçoit.

8. Circuit selon l'une quelconque des revendications 2 à 7, comprenant un détecteur de phase connecté de façon à recevoir un signal de sortie de la boucle à verrouillage de phase numérique, et l'un des premier et deuxième échantillons, et de mesurer le déphasage existant entre eux, et un réseau à dents d'élimination ayant pour fonction d'amincir les impulsions de sortie d'un oscillateur qui produit ledit signal de fréquence choisie à l'avance, en fonction du signal de sortie du détecteur de phase.

9. Montage, ou circuit, suivant le cas, selon l'une quelconque des revendications précédentes, où ladite table de conversion comprend une mémoire fixe.

10. Montage, ou circuit, selon l'une quelconque des revendications précédentes, où ledit premier signal est échantillonné à une fréquence valant quatre fois la fréquence du deuxième signal, si bien que la table de conversion doit nécessairement produire des valeurs relativement à un intervalle de $\pi/4$ de déphasages.

**Patentansprüche**

1. Schaltung zur Bewertung der Phasendifferenz zwischen ersten und zweiten Signalen ($f_R$, CL, Fig. 4), mit

einer Abtastschaltung zur Abtastung des ersten Signals ($f_R$) zu zwei Zeiten, welche in Abhängigkeit von dem zweiten Signal (CL) bestimmt sind und in Relation zu der Phase des ersten Signals einen Abstand voneinander aufweisen, um erste und zweite Abtastwerte ($y_0$, $y_1$) zu liefern,

einer Komparatoreinrichtung (113, Fig. 3), welche die Relation zwischen den absoluten Werten der ersten und zweiten Abtastwerte bewertet und ein entsprechendes Ausgangszeichen liefert,

einer Amplitudenverhältnisschaltung (114, 115, 116, 117), welche das Verhältnis der Amplituden der ersten und der zweiten Abtastwerte bestimmt und ein entsprechendes Ausgangszeichen liefert, und

einer Conversionstabelle (118) welche dazu dient, einen die genannte Phasendifferenz anzeigenden Wert zu liefern, in Abhängigkeit von den Vorzeichen der ersten und der zweiten Abtastwerte und von den Ausgangssignalen der Komparatoreinrichtung und der Amplitudenverhältnisschaltung.

2. Fangschaltung für eine digitale, phasenverriegelte Schleife, mit einer Schaltungsanordnung nach Anspruch 1, bei welcher das erste Signal ein Einfrequenzsignal ist, dessen Phase durch das zweite Signal angepaßt werden soll, welches ein Ausgangssignal einer digitalen, phasenverriegelten Schleife ist und durch Frequenzteilung eines Signals von vorbestimmter Frequenz mit Hilfe eines teilenden Zählers erhalten wird.

3. Schaltung nach Anspruch 2, bei welcher der genannte Wert, der die genannte Phasendifferenz anzeigt, dazu verwendet wird, einen anfänglichen Zählwert für den teilenden Zähler zu liefern.

11

4. Schaltung nach Anspruch 2, bei welcher der genannte Wert, der die genannte Phasendifferenz anzeigt, ein Maß für den ergänzenden Winkel des Phasenwinkels ist, welcher die genannte Phasendifferenz darstellt, und daß die Schaltung ein Einrichtung zur Verhinderung des Zählbetriebs des genannten teilenden Zählers während einer dem genannten ergänzenden Winkel entsprechenden Periode umfaßt.

5. Schaltung nach Anspruch 4, mit einem Abwärts-Zähler, in welchem der genannte Wert, der ein Maß des ergänzenden Winkels ist, gesetzt wird und der von diesem Wert abwärts zählen kann, und mit einer ersten Torschaltung, welche zwischen den teilenden Zähler und einen Oszillator geschaltet ist, welcher das genannte Signal mit der vorbestimmten Frequenz lierfert und die dazu dient, zu öffnen, um das genannte Signal vorbestimmter Frequenz zu dem teilenden Zähler hindurchzulassen, wenn der Abwärts-Zähler bis Null abwärts gezählt hat.

6. Schaltungsanordnung nach Anspruch 1 oder Schaltung nach einem der Ansprüche 2 bis 5, bei welcher die Komparatoreinrichtung ein Absolutwert-Netzwerk umfaßt, welches dazu dient, die entsprechenden absoluten Werte der ersten und der zweiten Abtastungen zu erhalten, und eine Subtrahiereinrichtung, welche dazu dient, die Differenz zwischen den von dem Absolutwert-Netzwerk erhaltenen absoluten Werten zu bestimmen.

7. Schaltungsanordnung oder Schaltung, wie es der Fall sein mag, nach Anspruch 6, bei welcher die Amplitudenverhältnisschaltung eine Selektoreinrichtung umfaßt, welche dazu dient, wahlweise die absoluten Werte der ersten und der zweiten Abtastung auf einen ersten bzw. einen zweiten Weg oder auf einen zweiten bzw. einen ersten Weg zu geben, von denen einer ein Reziprokwert-Netzwerk umfaßt, in Abhängigkeit von der Differenz, welche von der Subtrahiereinrichtung bestimmt worden ist, und eine Multipliziereinrichtung, welche mit dem ersten und dem zweiten Weg verbunden ist und zur Multiplikation der über diese empfangenen Werte dient.

8. Schaltung nach einem der Ansprüche 2 bis 7, mit einem Phasendetektor, welcher so angeschlossen ist, daß er ein Ausgangssignal von der digitalen, phasenverriegelten Schleife und den ersten oder den zweiten Abtastwert empfängt, um die Phasendifferenz zwischen diesen zu detektieren, und ein Zahnentfernungs-Netzwerk, welches dazu dient, Impulse eines Oszillators auszudünnen, welcher das genannte Signal vorbestimmter Frequenz in Abhängigkeit von dem Ausgangssignal des Phasendetektors liefert.

9. Schaltungsanordnung oder Schaltung, wie es der Fall sein mag, nach einem der vorhergehenden Ansprüche, bei welcher die genannte Conversionstabelle ein ROM umfaßt.

10. Schaltungsanordnung oder Schaltung, wie es der Fall sein mag, nach einem der vorhergehenden Ansprüche, bei welcher das genannte erste Signal mit einer Frequenz abgetastet wird, welche gleich viermal der Frequenz des zweiten Signals ist, wodurch die Conversionstabelle Werte in Bezug auf $\pi/4$ des Bereiches der Phasendifferenzen liefern muß.

Fig. 1

Fig. 2

0 053 939

Fig 3

Fig. 4

Fig. 5

(1)

$y_1 > 0 , y_0 < 0$

(2)

$y_1 > 0 , y_0 > 0$

(3)

$y_1 < 0 , y_0 > 0$

(4)

$y_1 < 0 , y_0 < 0$

Fig. 6

(1)

$|y_1| < |y_0|$

(2)

$|y_1| > |y_0|$

Fig. 7

5

Fig. 8

Fig 9